# EUROPÄISCHE PATENTSCHRIFT

(11) **EP 0 908 738 B1**
(45) Veröffentlichungstag und Bekanntmachung des Hinweises auf die Patenterteilung: **23.01.2002**
(21) Anmeldenummer: 98118920.2
(22) Anmeldetag: 07.10.1998
(51) Int. Cl.: G01R 33/28

(54) **NMR-Probenkopf mit integrierter Fernabstimmung**
NMR sample head with integrated remote tuning
Tête support d'échantillon pour la RMN avec réglage à distance intégré

(30) Priorität: 10.10.1997 DE 19744763
(43) Veröffentlichungstag der Anmeldung: 14.04.1999
(73) Patentinhaber: Bruker AG, 8117 Fällanden (CH)
(72) Erfinder: Triebe, René, 8051 Zürich (CH); Fenner, Jürg, 8600 Dübendorf (CH); Schett, Oskar, 8610 Uster (CH)
(74) Vertreter: KOHLER SCHMID + PARTNER

(56) Entgegenhaltungen:
- EP-A- 0 136 642
- EP-A- 0 518 100
- DE-A- 3 421 830
- DE-A- 3 825 525
- PATENT ABSTRACTS OF JAPAN vol. 016, no. 061 (C-0910), 17. Februar 1992 (1992-02-17) & JP 03 258242 A (TOSHIBA CORP), 18. November 1991 (1991-11-18)

## Beschreibung

Die Erfindung betrifft ein Kernspinresonanz (NMR) - Spektrometer mit einem NMR-Magneten, einem Probenkopf und einem Stellantrieb zur fernbedienten Verstellung von elektrischen und/oder mechanischen Einheiten, beispielsweise kapazitiven Trimmern, Regelwiderständen, verstellbaren Induktivitäten etc., im Probenkopf mit einer oder mehreren Antriebseinheiten, einer oder mehreren Getriebeeinheiten sowie einer oder mehreren Antriebswellen, die mit Justierungsstangen des Probenkopfes gekoppelt sind.

Ein NMR-Spektrometer mit einem solchen Stellantrieb ist beispielsweise aus der EP 0 518 100 B1 bekannt.

Weiterhin sind aus EP-A-0 136 642, JP-A-3 258 242 und DE-A-38 25 525 jeweils Stellantriebe für tomographische Anwendungen bekannt, bei denen das Magnetfeld des jeweiligen Tomographiemagneten als Stator für den Elektromotor des Antriebs dient.

Die heutigen Kernresonanz(NMR)-Spektrometer besitzen normalerweise einen leistungsfähigen Computer, der die Kontrolle über alle wichtigen Einstellungen und Parameter des Spektrometers übernimmt. Der Bediener des Spektrometers sitzt am Bedienungstisch und übermittelt von dort seine Anweisungen und Optimierungseinstellungen direkt an den Computer. Dies geschieht mit Hilfe eines Bildschirms, einer Maus, einer Computer-Tastatur sowie evtl. eines zusätzlichen Eingabegerätes mit Tasten und Knöpfen zur Übertragung von Spezialanweisungen. Der Computer seinerseits leitet dann diese Anweisungen in geeigneter Form an die entsprechenden elektronischen Einheiten des Spektrometers weiter.

Solange der Benutzer Messungen an derselben Messprobe vornimmt, steht ihm diese komfortable Arbeitsweise zur Verfügung. Wenn er hingegen eine neue Messprobe benutzen will, ist er gezwungen seinen Arbeitsplatz zu verlassen, um die neue Messprobe in den Magneten einzuführen. Besitzt diese neue Messprobe im Vergleich zur vorherigen auch noch eine unterschiedliche Dielektrizitätskonstante und elektrische Leitfähigkeit, dann muss er die Resonanzfrequenz sowie die Impedanzanpassung des NMR-Empfangsresonators manuell am Ort des Probenkopfes, d.h. am Ort des Magneten neu einstellen. Unter Impedanzanpassung versteht man die elektrische Anpassung des Resonators an das HF-Kabel und den anschliessenden Vorverstärker, so dass ein Maximum an Signalenergie den Vorverstärker erreicht.

Um den Komfort des Bedieners weiter zu verbessern, sind Einheiten, sogenannte Probenwechsler, entwickelt worden, die einen fernbedienten Wechsel einer grossen Anzahl von Messproben (z.B. 60 Stk) erlauben. Zudem sind auch fernbediente elektromechanische Einheiten, sogenannte Stellantriebe, entwickelt worden, mit denen sowohl kapazitive Trimmer wie auch fixe Kapazitäten im Probenkopf verstellt bzw. hinzu- oder weggeschaltet werden können (siehe EP 0 518 100 B1) .Auf diese Weise lassen sich die Resonanzfrequenz und die Impedanzanpassung des NMR-Resonators ebenfalls aus der Ferne einstellen.

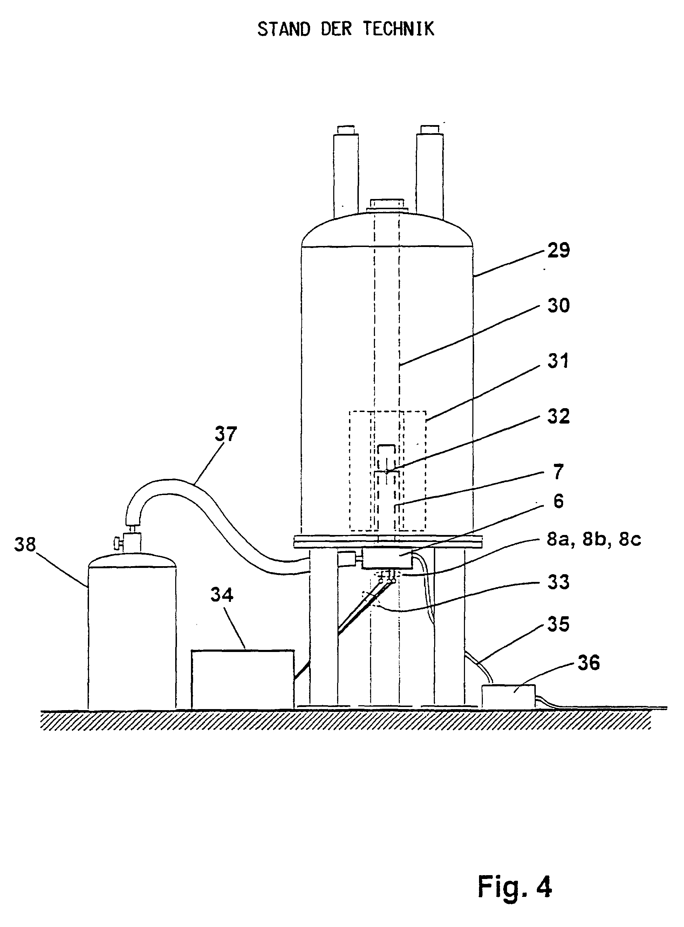

Durch die Benutzung von Probenwechsler und Stellantrieben wurde auch ein vollautomatischer Betrieb des Spektrometers über längere Zeitabschnitte und unter Benutzung verschiedener Messproben möglich. Dies geschieht dadurch, dass der Computer einen Auftragsplan erhält, den er in Anweisungen zur Einstellung der diversen Hardware-Komponenten umsetzt. Er fordert z.B. den Probenwechsler auf, eine bestimmte Messprobe in den Magneten einzuführen. Dazu muss zuerst Pressluft innerhalb der Bohrung 30 (siehe Fig. 4) eingeschaltet werden, damit die Probe auf einem Luftkissen vom oberen Ende der Bohrung 30 bis hinunter in den Bereich des magnetischen Zentrums 32 befördert werden kann. Der Druck der Pressluft muss dabei so geregelt werden, dass die Messprobe nicht zu schnell nach unten gleitet, da sie sonst beschädigt werden kann. Sobald die Messprobe ihre Endposition erreicht hat, muss die Pressluft wieder abgeschaltet werden. Anschliessend wird der Druck einer zweiten zugeführten Pressluft, die zum Antrieb der Luftturbine der Messprobe dient, so geregelt, dass die Messprobe mit einer vorgeschriebenen Frequenz rotiert. Alle diese Vorgänge laufen automatisch ab. Ausserdem gibt der Computer dem Stellglied Anweisungen, wie dieses die Kapazitätswerte verändern muss, damit eine optimale Einstellung der Resonanzfrequenz und der Impedanzanpassung des NMR-Resonators erreicht wird. Anschliessend startet er die vorgeschriebenen Messvorgänge, die von Probe zu Probe verschieden sein können. Ein solches Messvorgehen hat den grossen Vorteil, dass eine grosse Anzahl von Messproben (z.B. 60 Proben) in einem einzigen Messzyklus gemessen werden können, und zwar ohne menschliche Überwachung. Ein Messzyklus kann deshalb problemlos auch während der Nacht und übers Wochenende durchgeführt werden.

Die bekannten Stellantriebe 34 für Probenköpfe in NMR-Spektrometern (siehe Fig. 4) enthalten jeweils mindestens eine Antriebseinheit, die normalerweise aus einem Elektromotor besteht. Der Stellantrieb wird nicht zu nahe beim Magneten aufgestellt, da der Motor durch seine ferro- und permanentmagnetischen Komponenten die Homogenität des Hₒ-Feldes des Magneten negativ beeinflusst. Zudem können hohe elektromagnetische Kräfte zwischen der Magnetspule und dem Motor entstehen, die sowohl das Magnet/Dewar-System aber auch den Motor kritisch belasten könnten. Und nicht zuletzt verlieren diese Elektromotoren in hohen Streufeldern ihre Funktionstüchtigkeit. Aus diesem Grunde werden die Elektromotoren, die sich im Stellantrieb 34 befinden, in einem genügend grossen Abstand vom magnetischen Zentrum 32 des Magneten plaziert und über ein langes Verbindungsgestänge 33, das entweder aus einzelnen Gelenkwellen oder aus einzelnen flexiblen mechanischen Wellen besteht, mit den Justierungsstangen 8a, 8b, 8c des Probenkopfes verbunden. Es entstehen dadurch relativ schwerfällige Konstruktionen, die zusätzlichen Platz im Bereich unterhalb des Magneten versperren, d.h. in einem Bereich, der ohnehin aus technischen Gründen beschränkt ist und dem Benutzer wenig Bewegungsfreiheit bietet.

Aufgabe der vorliegenden Erfindung ist es demgegenüber, einen Stellantrieb für ein NMR-Spektrometer der eingangs beschriebenen Art so zu verbessern, dass er dem Benutzer mehr Bewegungsfreiheit und damit Komfort unterhalb des Magneten bietet, indem der Platzbedarf des Stellantriebes minimiert und der Zugang zum Bereich unterhalb des Magneten optimiert wird. Eine weitere Aufgabe der Erfindung besteht darin, die Installation des Stellantriebes bequemer zu gestalten. Bei den bekannten Stellantrieben muss der Benutzer nach jedem Wechsel des Probenkopfes das Verbindungsgestänge des Stellantriebes wieder an den Probenkopf ankoppeln. Beim erfindungsgemässen Stellantrieb soll das nicht mehr nötig sein.

Erfindungsgemäss werden diese Aufgaben dadurch gelöst, dass der Stellantrieb am NMR-Probenkopf befestigt ist, dass die Antriebseinheit(en) einen oder mehrere miniaturisierte Gleichstrommotoren mit als Stator dienenden Permanentmagneten und mit einem Volumen V ≤10cm³ zur Erzeugung von Drehmomenten umfassen, und dass der (die) miniaturisierte(n) Gleichstrommotor(en) im Streufeld des NMR-Magneten angeordnet ist (sind).

Dabei wird die zunächst unrealistisch anmutende Idee verwirklicht, den Stellantrieb direkt in den Probenkopf des NMR-Spektrometers zu integrieren, d.h. in die unmittelbare Nähe des magnetischen Zentrums zu plazieren. Dabei ist zunächst zu bedenken, dass das Platzangebot im Bereich des Probenkopfes sehr beschränkt ist, dass ein oder mehrere Elektromotoren in einem relativ hohen Streufeld des NMR-Magneten zuverlässig arbeiten müssten, und dass zudem das Hₒ-Feld des Magneten am Ort der Messprobe nicht zu stark beeinflusst werden darf. Dies sind Bedingungen, die eine Realisierung der erfindungsgemässen Idee auf den ersten Blick für den Fachmann unwahrscheinlich machen. Es erstaunt deshalb nicht, dass bis heute diese Idee nicht verwirklicht wurde, obwohl Stellantriebe für NMR-Probenköpfe seit über 6 Jahren, und miniaturisierte Komponenten, z.B. Motoren, Getriebe, etc., sogar seit noch längerer Zeit bekannt sind.

Aus der DE 34 21 830 A1 ist zwar ein Stellantrieb zur fernbedienten Verstellung eines kapazitiven Trimmers einer Hochfrequenzantenne in einem NMR-Tomographen mit einer Antriebseinheit, einer Getriebeeinheit sowie einer Antriebswelle bekannt, der mit der Hochfrequenzantenne baulich vereinigt ist und somit als "integraler Bestandteil" der Hochfrequenzantenne betrachtet werden kann, jedoch wird in der DE 34 21 830 A1 ausdrücklich darauf verwiesen, dass Schrittmotoren in NMR-Apparaturen grundsätzlich ausserhalb des Hauptfeldmagneten angeordnet werden müssen, um die Feldhomogenität nicht zu stören und um selbst nicht durch das Streufeld in ihrer Funktion beeinträchtigt zu werden. Dies läuft der erfindungsgemässen Plazierung der Gleichstrommotoren im Streufeld des Hauptfeldmagneten diametral zuwider.

Der Schlüssel zur Realisierung der erfindungsgemässen Idee liegt einerseits in einer konsequenten Miniaturisierung des Stellantriebes und andererseits in einer Optimierung der Funktionstüchtigkeit der Antriebseinheit in hohen Streufeldern.

Durch eine massive Verkleinerung der am stärksten störenden Komponente, nämlich des Elektromotors in der Antriebseinheit, lässt sich sein Einfluss auf das Hₒ-FeId stark verringern. Wenn nämlich die Masse der ferro- und permanentmagnetischen Materialien in der Nähe des Magneten klein gehalten wird, dann ist auch ihr Einfluss auf die Homogenität des Magneten klein. Anders ausgedrückt: wird die gesamte Masse der ferro- und permanentmagnetischen Materialien reduziert, dann darf diese auch näher beim Magneten liegen. Ein stark miniaturisierter Elektromotor, d.h. ein Kleinstmotor, kann deshalb direkt am unteren Teil des Probenkopfes befestigt werden, ohne dass dadurch das Hₒ-FeId am Ort der Messprobe zu stark beeinflusst wird. Ausserdem ist die Miniaturisierung auch eine der Voraussetzungen, damit eine Integration des Stellantriebes im Probenkopf überhaupt möglich wird.

Besonders vorteilhaft ist eine Ausführungsform der Erfindung, bei der die miniaturisierten Gleichstrommotoren integrierte Miniatur-Getriebe aufweisen, wodurch die Antriebs- und Getriebeeinheiten besonders kompakt gestaltet werden können.

Solche Kleinstmotoren mit genügend grossem Drehmoment sind als Gleichstrom(DC)- Motoren kommerziell erhältlich, haben Abmessungen in der Grössenordnung von 7mm x 20mm (ohne Getriebe) und 7mm x 30mm (mit Getriebe) und liefern ein Drehmoment von ca. 0.035 Nm (mit Getriebe) .Ein innen liegender Stator besteht aus einem zylinderförmigen Permanentmagneten (z.B. Alnico), dessen Feld-Rückschluss über einen aussen liegenden Stahlzylinder erfolgt. Dazwischen liegt ein Rotor, der kein Eisen enthält, aus Kupferwicklungen besteht und einen Kommutator besitzt.

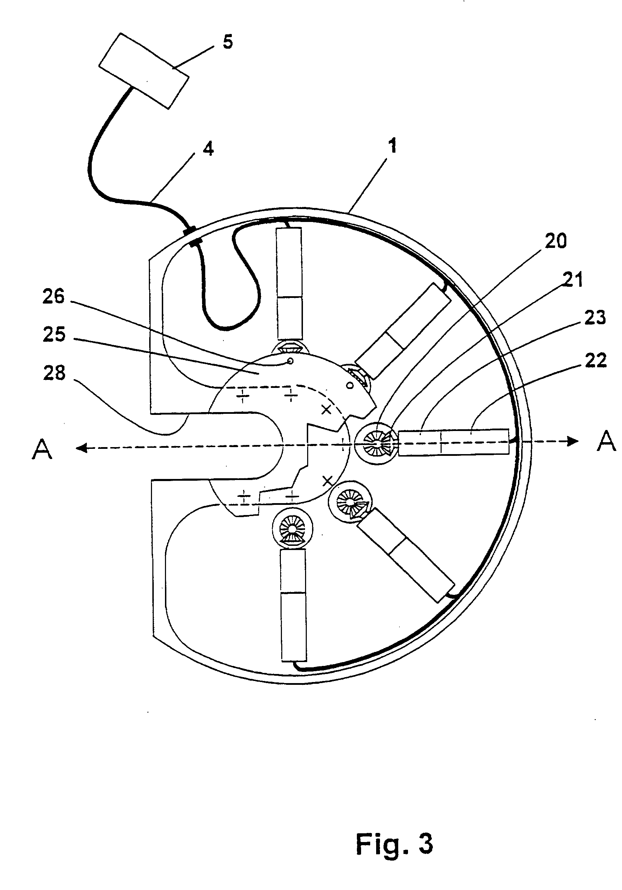

Versuche haben gezeigt, dass sogar mehrere solcher Kleinstmotoren (siehe Fig. 3) am unteren Teil des Probenkopfes befestigt werden können, ohne dass dadurch das Hₒ-Feld am Ort der Probe zu stark beeinflusst wird.

Weitere Versuche haben gezeigt, dass diese Kleinstmotoren im Streufeld von aktiv abgeschirmten NMR-Magneten gut funktionieren, solange das Feld im Zentrum des Magneten ca. 10 Tesla nicht überschreitet. Sogar im Streufeld von nicht aktiv abgeschirmten NMR-Magneten funktionieren diese Motoren gut bis zu einem Feld von ca. 7 Tesla im Zentrum des Magneten.

Werden diese Grenzwerte jedoch stark überschritten, dann verschlechtert sich die Funktionstüchtigkeit des Kleinstmotors zunehmend. Diese Verhaltensweise ist auch bei normalen Elektromotoren zu beobachten und hat zur verständlichen Meinung geführt, dass Elektromotoren gerade wegen ihrer Funktionsweise nicht in höheren Streufeldern betrieben werden dürften. Dass jedoch die verminderte Funktionstüchtigkeit insbesondere durch Reibung in den Lagern und erst in zweiter Linie durch die Funktionsweise des Motors hervorgerufen wird, wurde vorher nicht klar erkannt, und dies ist, neben der Beeinflussung des Hₒ-Feldes, ein weiterer Grund, warum im Bereich der NMR keine Elektromotoren in höheren Streufeldern betrieben wurden.

Die Reibung in den Lagern von Kleinstmotoren entsteht dadurch, dass die Achsen des Motors und des dazugehörenden Getriebes, die im Allgemeinen aus Stahl hergestellt sind, infolge der auftretenden magnetischen Kräfte stark gegen die sie führenden Gleitlager gedrückt werden und dort zusätzliche Reibung hervorrufen. Das ohnehin geringe Drehmoment solcher Kleinstmotoren genügt dann nicht mehr, um diese Reibung zu überwinden. Stellt man jedoch diese Achsen aus möglichst nicht-magnetischen Materialien mit genügend hoher mechanischer Festigkeit her (z.B. Bronze-Legierungen) , dann lässt sich auch dieses Problem lösen.

Ist das Reibungsproblem gelöst, dann können neue Probleme auftreten, die mit der Funktionsweise des Elektromotors zusammenhängen. Das Streufeld des NMR-Magneten hat nämlich einen Einfluss auf die magnetischen Zustände innerhalb des Motors und kann auf diese Weise dessen Funktionstüchtigkeit verschlechtern. Die Orientierung des Permanentmagneten im Motor in Bezug auf das Streufeld des NMR-Magneten sollte deshalb so gewählt werden, dass der Motor möglichst optimal funktioniert. Dabei sind zwei physikalische Eigenheiten zu beachten: Erstens sind das magnetische Feld im Innern des Permanentmagneten und das Feld im Luftspalt des Motors entgegengesetzt zueinander gerichtet, und zweitens vermag das Streufeld des NMR-Magneten den Permanentmagneten abzuschwächen, wenn einerseits das Streufeld entgegengesetzt zum Feld im Innern des Permanentmagneten gerichtet ist, und anderseits die Koerzitivkraft des Permanentmagneten klein ist. Wenn die Feldstärke des Streufeldes klein gegenüber der Koerzitivkraft des Permanentmagneten ist, dann bedeutet dies, dass das Streufeld praktisch keinen Einfluss auf den Permanentmagneten besitzt. In diesem Fall sollte das Streufeld und das Feld im Luftspalt des Permanentmagneten möglichst dieselbe Richtung besitzen, damit das Feld im Luftspalt und damit das Drehmoment vergrössert wird.

Wenn hingegen die Feldstärke des Streufeldes vergleichbar mit der Koerzitivkraft des Permanentmagneten ist, dann sollte die Orientierung des Motors so gewählt werden, dass das Streufeld des NMR-Magneten das Feld im Innern des Permanentmagneten unterstützt, d.h. im wesentlichen die gleiche Richtung besitzt. Man verhindert dadurch eine Abschwächung des Permanentmagneten, führt aber anderseits eine Abschwächung des Feldes im Luftspalt des Motors herbei und damit eine Verringerung des Drehmomentes. Wäre jedoch an Stelle des Luftspaltes der Permanentmagnet geschwächt worden, hätte dies zu einer noch viel stärkeren Reduktion des Drehmomentes führen können.

Das maximale Drehmoment dieser Kleinstmotoren ist natürlich begrenzt. Durch eine Herabsetzung der ursprünglichen Drehzahl mit Hilfe von Getrieben lässt sich das Drehmoment zwar erhöhen, allerdings auf Kosten einer langsameren Einstellgeschwindigkeit. Anderseits bietet die Integration des Stellantriebes in den Probenkopf den Vorteil, dass keine Umlenkwellen oder flexible Wellen benötigt werden. Letztere erfordern nämlich umso grössere Drehmomente, je weiter das Stellglied seitlich vom Probenkopf angeordnet werden muss. Dies ist einer der Gründe, warum das relativ kleine Drehmoment des Kleinstmotors dem vorliegenden Anwendungszweck genügt.

Vorteilhaft ist auch eine Ausführungsform des erfindungsgemäss modifizierten Stellantriebs, bei der die Getriebeeinheiten Kegelrad-Getriebe sowie eine um 90° zur Welle der jeweiligen Antriebseinheit gedrehte Antriebswelle aufweisen. Damit können die Antriebseinheiten seitlich von der Hochachse des NMR-Aufbaus weg angeordnet sein, so dass der niedrige Raum unterhalb des üblicherweise verwendeten NMR-Kryostaten besser ausgenutzt werden kann. Auch die Montage des Stellantriebs vereinfacht sich damit. Ausserdem können durch entsprechende Verwendung von Kegel-Zahnrädern bei den Kegelrad-Getrieben jeweils gewünschte Drehzahlübersetzungsverhältnisse zwischen dem Antriebsmotor und der damit bedienten Justierungsstange eingestellt werden.

Bei einer weiteren bevorzugten Ausführungsform weist die Antriebswelle eine Rutschkupplung auf. Dadurch kann der Aufbau von übermässig grossen Drehmomenten und eine daraus resultierende Beschädigung im Probenkopfbereich vermieden werden.

Eine besonders einfache und damit schnelle Montage an den Probenkopf erlaubt eine Ausführungsform des erfindungsgemäss modifizierten Stellantriebs, bei der die Antriebswellen selbständig in die Justierungsstangen einrasten können.

Die Miniaturisierung des Stellantriebes und dessen Integration in den Probenkopf führt zudem zu einer Reduktion der Herstellungskosten. Da die genannten Kleinstmotoren mit angebauten Getrieben ein breites Anwendungsgebiet besitzen, werden sie in grossen Serien hergestellt und sind deshalb relativ billig. Dadurch kann für jeden Probenkopf ein eigener Stellantrieb eingebaut werden, ohne dass dadurch die Kosten zu hoch werden. Der Austausch von Probenköpfen, unter Beibehaltung einer fernbedienten Resonanz- und Impedanzanpassung, ist deshalb mit dem erfindungsgemäss modifizierten Stellantrieb äusserst einfach und elegant durchzuführen.

Auch wenn nur ein einziger erfindungsgemäss modifizierter Stellantrieb zur Verfügung steht, so dass bei einem Wechsel des Probenkopfes eine Montage des Stellantriebes an den neuen Probenkopf notwendig wird, sind deutliche Vorteile der erfindungsgemässen Modifikation gegenüber herkömmlichen Antriebseinrichtungen erkennbar. Die Demontage und Montage braucht nämlich nicht mühsam unterhalb des NMR-Magneten durchgeführt zu werden, sondern kann bequem auf einem Tisch erfolgen, wobei anschliessend das montierte System als Ganzes in den NMR-Magneten eingeführt wird.

Weitere Vorteile der Erfindung ergeben sich aus der Beschreibung und der Zeichnung. Die gezeigten und beschriebenen Ausführungsformen sind nicht als abschliessende Aufzählung zu verstehen, sondern haben vielmehr beispielhaften Charakter für die Schilderung der Erfindung.

Die Erfindung ist in der Zeichnung dargestellt und wird anhand von Ausführungsbeispielen näher erläutert. Es zeigen:
- Fig.1a: eine schematisierte Seitenansicht eines NMR-Probenkopfes;
- Fig.1b: einen zum NMR-Probenkopf nach Fig. 1a passenden erfindungsgemässen Stellantrieb;
- Fig. 1c: den NMR-Probenkopf nach Fig. 1a mit eingebautem Stellantrieb nach Fig. 1b;
- Fig.1d: den Aufbau nach Fig. 1c ergänzt um eine elektronische Steuereinheit;
- Fig.2a: einen vergrösserten, schematischen vertikalen Teilschnitt durch den Aufbau nach Fig. 1c;
- Fig.2b: eine Seitenansicht auf das in Fig. 2a gezeigte Übertragungsteil;
- Fig.3: eine horizontale Schnittansicht von oben auf die Antriebs- und Getriebeeinheiten nach Fig. 2a; und
- Fig.4: eine schematisierte, teilweise transparente Seitenansicht auf ein NMR-Spektrometer nach dem Stand der Technik.

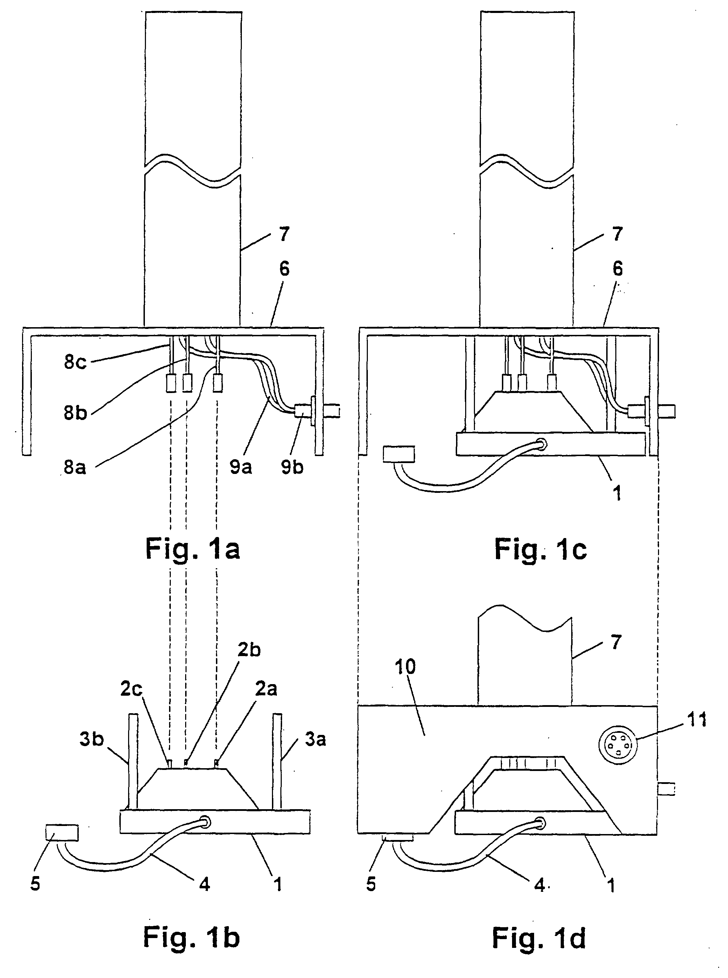

Fig.1a zeigt einen NMR-Probenkopf bestehend aus einem Unterteil 6 und einem Oberteil 7. Im Unterteil sind HF-Kabel 9a zu sehen, mit denen die Verbindungen von den NMR-Empfangsspulen mit ihren Anpassungsnetzwerken zu den HF-Ausgangsbuchsen 9b hergestellt werden. Von den HF-Ausgangsbuchsen 9b wird das NMR-Signal wiederum über HF-Kabel 35 (siehe Fig. 4) zu Vorverstärkern 36 (siehe Fig. 4) geführt, die im Allgemeinen etwas ausserhalb des Streufeldes des NMR-Magneten montiert werden. Im Unterteil 6 sind auch die Justieruncsstangen 8a, 8b, 8c zu sehen, mit denen die Kapazitäten für die Resonanz- und Leistungsanpassung eingestellt werden. Es sind drei solche Justierungsstangen dargestellt, es können aber auch weniger oder mehr vorhanden sein.

Fia.1b zeigt eine Ausführungsform des erfindungsgemässen Stellantriebs 1, der in seinem Innern mehrere Kleinstmotoren eingebaut hat (siehe Fig. 3). Auf der oberen Seite sind Antriebswellen 2a, 2b, 2c zu sehen, wobei jede von einem separaten Kleinstmotor angetrieben wird und am äusseren Ende einen schraubenzieherförmigen Ansatz besitzt. Diese Enden passen in die geschlitzten Enden der Justierungsstangen 8a, 8b, 8c, so dass eine Übertragung der Drehmomente der Antriebswellen auf die Justierungsstangen 8a, 8b, 8c ermöglicht wird.

Die von den Kleinstmotoren benötigte elektrische Energie wird über einen Stecker 5 und eine elektrische Zuleitung 4 geliefert. Der Stellantrieb 1 wird mit Hilfe von Bolzen 3a, 3b (es sind nur zwei dargestellt, die anderen sind verdeckt und nicht zu sehen) an das Unterteil 6 des Probenkopfes geschraubt.

Fig.1c zeigt den Stellantrieb 1, der an das Unterteil 6 des Porbenkopfes angeschraubt ist. Die Antriebswellen 2a, 2b, 2c und die Justierungsstangen 8a, 8b, 8c sind im eingerasterten Zustand gezeigt.

In Fig.1d ist eine zum Stellantrieb 1 gehörende Elektronik-Einheit 10 dargestellt. Diese erhält über eine Buchse 11 die benötigten Steuerbefehle von einem Rechner und setzt sie in entsprechende Stromwerte um, die sie an die einzelnen Kleinstmotoren weiterleitet. Die elektrische Verbindung zwischen den Kleinstmotoren im Stellantrieb 1 und der Elektronik-Einheit 10 verläuft über das Kabel 4 und den Stecker 5.

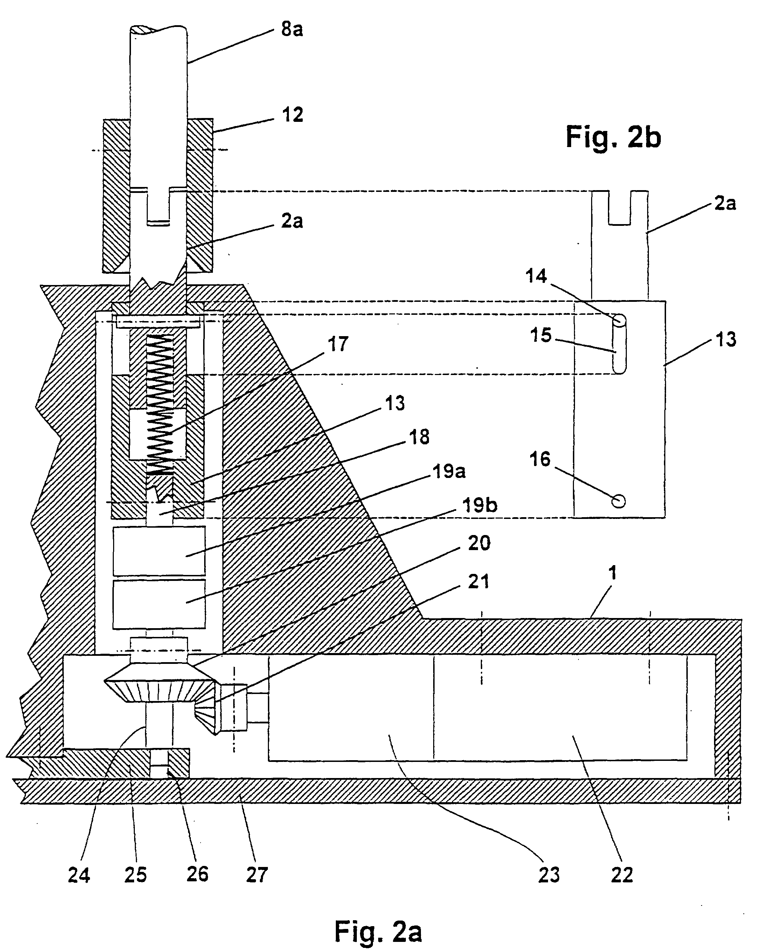

Fig.2a zeigt einen Schnitt durch den erfindungsgemässen Stellantrieb 1. Die Übertragung des Drehmomentes des Kleinstmotors 22 auf die Antriebswelle 2a erfolgt über folgende drei Komponenten:
1. ein mehrstufiges Getriebe 23, mit dem die hohe Drehzahl des Motors reduziert und das Drehmoment vergrössert wird;
2. ein Umlenkgetriebe, das sich aus den beiden Kegelzahnrädern 20 und 21 zusammensetzt; dieses überträgt das Drehmoment von der horizontalen auf die vertikale Achse und liefert ausserdem eine zusätzliche Untersetzung;
3. eine Rutschkupplung 19a, 19b, mit der das maximale Drehmoment, das bei einem Fehlbetrieb auftreten könnte, begrenzt wird. Dadurch wird eine Zerstörung von Einzelteilen des Stellantriebes 1 vermieden.

Um ein automatisches Einrastern der Antriebswelle 2a und der Justierungsstange 8a zu gewährleisten, ist ein Übertragungsteil 13 vorgesehen, das in Fig.2b in Seitenansicht dargestellt ist. Dieses erlaubt mit Hilfe eines Bolzens 14 und eines Schlitzes 15 eine Übertragung des Drehmoments, und mit Hilfe einer Feder 17 und dank dem Schlitz 15 ein genügend grosses Spiel entlang der Achse der Antriebswelle 2a. Beides zusammen führt dazu, dass erstens das Drehmoment übertragen, und zweitens ein automatisches Einrastern zwischen dem Schlitz der drehenden Antriebswelle 2a und dem schraubenzieherförmigen Ansatz der Justierungsstange 8a erreicht wird.

Eine Führungshülse 12, die an der Justierungsstange 8a befestigt ist, dient dazu, die Positionierung der Antriebswelle 2a und der Justierungsstange 8a zu erleichtern. Eine Führungsplatte 25 ist mit einzelnen Gleitlagern 26 versehen, mit denen der untere Abschnitt 24 der Antriebswelle 18, an der das Übertragungsteil 13 mittels eines Bolzens 16 befestigt ist, sowie aller anderen Antriebsachsen geführt werden. Der untere Bereich des Stellantriebes ist mit einer Abdeckung 27 abgeschlossen.

Fig.3 zeigt die Ansicht des Stellantriebes 1 von unten gesehen und ohne die Abdeckung 27. Die Schnittebene A-A definiert die Schnittzeichnung von Fig.2a. Ein Teil der Führungsplatte 25 mit seinen Gleitlagern 26 ist ebenfalls zu sehen. Der Stellantrieb enthält fünf Kleinstmotoren, es können jedoch auch weniger oder mehr vorhanden sein. Im Einzelnen zu erkennen sind die beiden Kegelzahnräder 20 und 21, das miniaturisierte mehrstufige integrierte Planetengetriebe 23 sowie der Motor 22. Die elektrischen Verbindungen zu den einzelnen Motoren sind im Kabel 4 zusammengefasst, und dieses ist mit dem Stecker 5 verbunden.

Ein Schlitz 28 liefert den nötigen Raum, um das Transfer-Dewar, das das Unterteil 6 des Probenkopfes mit dem unteren Bereich der Empfangsspule verbindet, zu montieren. Dieses Transfer-Dewar ist ein Teil einer Temperiereinheit 38 (siehe Fig. 4), mit der die NMR-Messprobe auf unterschiedliche Temperaturen gebracht werden kann.

Fig. 4 zeigt den heutigen Stand der Technik. In einem Kryostaten 29 befindet sich ein supraleitender NRM-Magnet 31. Der Kryostat 29 besitzt eine durchgehende, senkrechte Bohrung 30, normalerweise mit einem Durchmesser von ca. 5 cm, die auf Zimmertemperatur liegt. Ein Probenkopf, der aus dem Unterteil 6 und dem Oberteil 7 besteht, befindet sich in der Bohrung 30, und zwar so, dass das Zentrum der NMR-Empfangsspule mit dem Zentrum des Magneten 31 übereinstimmt und durch einen Punkt 32 definiert ist. Am Unterteil 6 des Probenkopfes befinden sich die Justierungsstangen 8a, 8b, 8c, die über ein Verbindungsgestänge 33 mit einem herkömmlichen Stellantrieb 34 verbunden sind. Das Verbindungsgestänge 33 hat die Aufgabe, die im Stellantrieb 34 erzeugten Drehmomente auf die Justierungsstangen 8a, 8b, 8c zu übertragen.

Das hochfrequente NMR-Signal wird vom Unterteil 6 des Probenkopfes über die HF-Verbindungskabel 35 zu den Vorverstärkern 36 geführt. An das Unterteil 6 des Probenkopfes ist zudem ein thermisch isoliertes und flexibles Verbindungsrohr 37 angeschlossen, das mit der Temperiereinheit 38 verbunden ist und dazu dient, ein gekühltes oder erwärmtes Gas (normalerweise Stickstoff) von der Temperiereinheit 38 zum Probenkopf zu führen, wo es dann über ein im Probenkopf montiertes Glasdewar zur Messprobe gelangt.

Fig. 4 illustriert deutlich, wie der Bereich unterhalb des NMR-Magneten 31 durch diverse Anordnungen, insbesondere das Verbindungsgestänge 33, versperrt wird und den freien Zugang zum Probenkopf behindert.

## Patentansprüche

1. NMR-Spektrometer mit einem Kernspinresonanz(NMR)-Magneten (31), einem Probenkopf (6, 7) und einem Stellantrieb zur fernbedienten Verstellung von elektrischen und/oder mechanischen Einheiten, beispielsweise kapazitiven Trimmern, Regelwiderständen, verstellbaren Induktivitäten etc., im Probenkopf (6,7) mit einer oder mehreren Antriebseinheiten, einer oder mehreren Getriebeeinheiten sowie einer oder mehreren Antriebswellen, die mit Justierungsstangen (8a, 8b, 8c) des Probenkopfes gekoppelt sind,
**dadurch gekennzeichnet,**
**dass** der Stellantrieb (1) am NMR-Probenkopf (6,7) befestigt ist, dass die Antriebseinheit(en) einen oder mehrere miniaturisierte Gleichstrommotoren (22) mit als Stator dienenden Permanentmagneten und mit einem Volumen V≤10cm³ zur Erzeugung von Drehmomenten umfassen, und dass der (die) miniaturisierte(n) Gleichstrommotor(en) (22) im Streufeld des NMR-Magneten (31) angeordnet ist (sind).

2. NMR-Spektrometer nach Anspruch 1, **dadurch gekennzeichnet, dass** die miniaturisierten Gleichstrommotoren (22) integrierte Miniatur-Getriebe (23) aufweisen.

3. NMR-Spektrometer nach Anspruch 1 oder 2, **dadurch gekennzeichnet, dass** die miniaturisierten Gleichstrommotoren (22) in einem Streufeld arbeiten können, das kleiner als die Koerzitivkraft von als Stator der Gleichstrommotoren (22) dienenden Permanentmagneten ist, wobei das Magnetfeld im Luftspalt jedes Motors weitgehend in gleicher Richtung wie das Streufeld des NMR-Magneten am Ort des Luftspalts orientiert ist.

4. NMR-Spektrometer nach Anspruch 1 oder 2, **dadurch gekennzeichnet, dass** die miniaturisierten Gleichstrommotoren (22) in einem Streufeld arbeiten können, das mit der Koerzitivkraft von als Stator der Gleichstrommotoren (22) dienenden Permanentmagneten vergleichbar ist, wobei das Feld innerhalb der Permanentmagneten weitgehend in gleicher Richtung wie das Streufeld des NMR-Magneten am Ort der Permanentmagneten orientiert ist.

5. NMR-Spektrometer nach einem der vorhergehenden Ansprüche, **dadurch gekennzeichnet, dass** die Getriebeeinheiten Kegelrad-Getriebe (20, 21) sowie eine um 90° zur Welle der jeweiligen Antriebseinheit gedrehte Antriebswelle (18) aufweisen.

6. NMR-Spektrometer nach einem der vorhergehenden Ansprüche, **dadurch gekennzeichnet, dass** an der Antriebswelle (18) eine Rutschkupplung (19a, 19b) vorgesehen ist.

7. NMR-Spektrometer nach einem der vorhergehenden Ansprüche, **dadurch gekennzeichnet, dass** die Antriebswellen selbständig in die Justierungsstangen (8a, 8b, 8c) einrasten können.

## Claims

1. NMR spectrometer comprising a nuclear magnetic resonance (NMR) magnet (31), a probe head (6,7) and an actuator for remote-controlled adjustment of electrical and/or mechanical units, in particular trimmer capacitors, variable resistors, adjustable inductors and the like in a probe head (6,7), with one or more drive units, one or more transmission units as well as one or more drive shafts coupled to adjustment rods (8a,8b,8c) of the probe head,
**characterized in that**
the actuator (1) is mounted to the NMR probe head (6,7), the drive unit(s) comprise(s) one or more miniaturized DC-motors (22) comprising permanent magnets serving as stator and having a volume V≤10cm³ for producing torques, and that the miniaturized DC-motor(s) (22) is (are) disposed in the fringe field of the NMR magnet (31).

2. NMR spectrometer according to claim 1, **characterized in that** the miniaturized DC-motors (22) comprise integrated miniature transmissions (23).

3. NMR spectrometer according to claim 1 or 2, **characterized in that** the miniaturized DC-motors (22) can operate in a fringe field which is smaller than the coercive force of the permanent magnets acting as stator for the DC-motors (22), wherein the magnetic field in the air gap of each motor is oriented substantially in the same direction as the fringe field of the NMR magnet at the location of the air gap.

4. NMR spectrometer according to claim 1 or 2, **characterized in that** the miniaturized DC-motors (22) can operate in a fringe field which is comparable to the coercive force of the permanent magnets acting as stator for the DC-motors (22), wherein the field within the permanent magnet is oriented substantially in the same direction as the fringe field of the NMR magnet at the location of the permanent magnets.

5. NMR spectrometer according to any one of the preceding claims, **characterized in that** the transmission units comprise beveled gear wheel drives (20,21) as well as a drive shaft (18) rotated by 90° with respect to the shaft of the respective drive unit.

6. NMR spectrometer according to any one of the preceding claims, **characterized in that** a sliding clutch (19a,19b) is provided for on the drive shaft (18).

7. NMR spectrometer according to any one of the preceding claims, **characterized in that** the drive shafts can automatically snap into the adjustment rods (8a,8b,8c).

## Revendications

1. Spectromètre RMN comportant un aimant à résonance magnétique nucléaire (RMN) (31), une tête support d'échantillon (6, 7) et une servocommande pour le réglage à distance d'organes électriques et/ou mécaniques tels que condensateurs ajustables, résistances variables, inductances réglables, etc. dans la tête support d'échantillon (6, 7) au moyen d'un ou plusieurs organes d'entraînement, d'un ou plusieurs organes de transmission ou de réduction ainsi qu'un ou plusieurs arbres de transmission couplés à des tiges de réglage de la tête support d'échantillon,
**caractérisé par le fait**
**que** la servocommande (1) est fixée sur la tête support d'échantillon (6, 7), que le(s) organe(s) d'entraînement comprend/comprennent un ou plusieurs moteurs à courant continu miniaturisés (22) à aimant permanent servant de stator et d'un volume V ≤ 10 cm³ pour la génération de couples, et que le(s) moteur(s) à courant continu miniaturisé(s) (22) est/sont disposé(s) dans le champ de fuite de l'aimant RMN.

2. Spectromètre RMN selon la revendication 1, **caractérisé par le fait que** les moteurs à courant continu miniaturisés (22) présentent des réducteurs miniatures intégrés.

3. Spectromètre RMN selon la revendication 1 ou 2, **caractérisé par le fait que** les moteurs à courant continu miniaturisés (22) peuvent fonctionner dans un champ de fuite plus petit que la force coercitive des aimants permanents servant de stator des moteurs à courant continu (22), le champ magnétique dans l'entrefer de chaque moteur étant orienté globalement dans le même sens que le champ de fuite de l'aimant RMN à l'emplacement de l'entrefer.

4. Spectromètre RMN selon la revendication 1 ou 2, **caractérisé par le fait que** les moteurs à courant continu miniaturisés (22) peuvent fonctionner dans un champ de fuite comparable à la force coercitive des aimants permanents servant de stator aux moteurs à courant continu (22), le champ magnétique à l'intérieur des aimants permanents étant orienté globalement dans le même sens que le champ de fuite de l'aimant RMN à l'emplacement des aimants permanents.

5. Spectromètre RMN selon l'une des revendications précédentes, **caractérisé par le fait que** les organes de réduction présentent un engrenage conique (20, 21) ainsi qu'un arbre de transmission (18) faisant un angle de 90° avec l'organe d'entraînement concerné.

6. Spectromètre RMN selon l'une des revendications précédentes, **caractérisé par le fait qu'**un accouplement glissant (19a, 19b) est prévu sur l'arbre de transmission (18).

7. Spectromètre RMN selon l'une des revendications précédentes, **caractérisé par le fait que** les arbres de transmission peuvent s'engager automatiquement dans les tiges de réglage (8a, 8b, 8c).
